# EUROPEAN PATENT APPLICATION

(11) **EP 0 600 729 A1**
(43) Date of publication of application: **08.06.1994**
(21) Application number: 93309620.8
(22) Date of filing: 01.12.1993
(51) Int. Cl.: G06F 11/00, G06F 12/08

(54) **Data storage arrangement**

(30) Priority: 04.12.1992 GB 9225394; 03.02.1993 GB 9302082
(71) Applicant: PLESSEY SEMICONDUCTORS LIMITED, Swindon, Wiltshire SN2 2QW (GB)
(72) Inventor: Phillips, Ian, Plymouth, Devon PL6 7QE (GB)
(74) Representative: Hoste, Colin Francis

(57) **Abstract**

In a data processing system utilising fast-access cache memory, data words written in to the cache from main memory are immediately read and checked against the original, any discrepancies resulting in the lock-out of that cache location so that next time the processor calls up that data word it is again read from main memory and is written into another location in cache. The system is thereby tolerant of defective cache locations.

## Description

The present invention relates to data storage arrangements and to methods of storing data. In particular although not exclusively the invention relates to data storage arrangements for data processors in which fast access cache memory is used to increase processing speed.

Cache memory is arranged where possible to hold data relating to program loops currently being executed by the associated processor, using static random access memory (SRAM) with an access time of typically 15 to 20 nsec. The cache memory has to store both data and address, and must be able to make fast comparisons of address to indicate whether particular data required is available from the cache. If it is available the processor can continue operating at full speed. If not, the information must be read from main memory, which may be dynamic random access memory (DRAM) with an access time of typically 80 to 100 nsec.

The performance of a cache memory arrangement may be measured by its "hit-rate", that is, the proportion of its operating time that the processor is able to run from the cache memory. Clearly bit-rates are dependent on the program being run, but are always improved by using a larger cache memory and, as with main memory, the user always wants more.

All semiconductor devices have a cost which is ultimately related to the defects which occur in the process by which they are fabricated. Defects are flaws in the process and are typically measured in defects per square centimetre. As chips get larger they catch more defects, fewer devices are entirely free of defects and their individual cost rises. Memory devices in particular are very dense and very large, and defect density is the main parameter which affects their selling price. Consequently much effort has been expended to reduce this dependency, principally by the use of redundancy, the inclusion of spare circuit elements which are used to "repair" defective circuit elements.

It is an object of the present invention to use such memory devices in an arrangement which is tolerant of such defects.

According to one aspect of the present invention in a data storage arrangement in which a data packet or word held in a first data store is arranged to be written in to a storage location in a second data store in association with an identifier by means of which said data packet may be located when read-out of said data packet is required, there are provided means to read the data packet from said storage location once it has been written and to compare said data packet as read out with the said data packet as held in said first data store and to inhibit subsequent read-out from said storage location if any discrepancy is detected by said comparison.

According to another aspect of the present invention in a data storage arrangement comprising main memory and fast-access cache memory, in which a data packet or word held in said main memory is arranged to be written in to a storage location in said cache memory in association with an address identifier by means of which said data packet may be located when read-out is required, there are provided means to read the data packet from said storage location once it has been written and to compare said data packet as read out with the same data packet as held in main memory, and to inhibit subsequent writing of a data packet to or read-out of said data packet from said storage location in the cache memory if any discrepancy is detected by the comparison.

According to another aspect of the present invention in a data processing arrangement a method of writing data from main memory to cache memory comprises the steps of writing a given data word from said main memory to a storage location in said cache memory in association with a tag or identifer by means of which said data word may be retrieved when said data word is to be read out, reading the data word from said storage location and comparing it with the given data word from said main memory, and inhibiting subsequent retrieval and read-out of said data word from said location if any discrepancy is detected by the comparison.

The given data word may be written in to a reference register or a reference location in said cache memory for the purpose of making said comparison. One or more additional data bits may be included in said data word, and said subsequent retrieval and read-out from said location may be inhibited if the data word on read-out from said location fails a sum-check or parity check.

According to another aspect of the present invention in a data processing arrangement a method of writing data from a first storage medium to a second storage medium, comprises the steps of writing a given block of data from said first storage medium to a storage location in said second storage medium in association with an identifier by means of which said block of data may be retrieved when said block of data is to be read out, reading the block of data from said storage location once it has been written and comparing it with the same block of data as held in said first storage medium, and inhibiting subsequent read-out of said block of data if any discrepancy is detected by the comparison.

Where the processing arrangement requires contiguous address spaces for blocks of data in said second storage medium, the identifiers of blocks of data stored out of sequence may be mapped so as to exclude defective storage locations from the memory space to be used.

A data storage arrangement and method in accordance with the present invention will now be described with reference to the accompanying drawing, of which:-
Figure 1 shows diagrammatically a cache memory, and
Figure 2 illustrates a method of writing data to a cache memory.

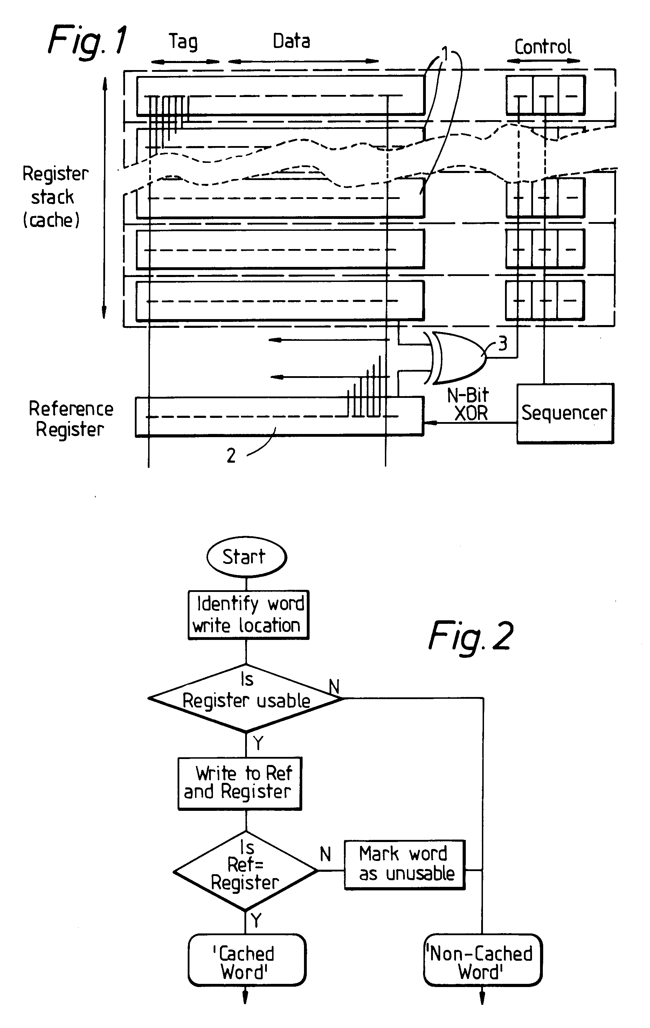

Referring first to Figure 1 a cache memory in accordance with the present invention comprises a plurality of storage locations or registers 1 each of which is arranged to hold both the data bits of a word or packet and a number of bits making up a tag or identifier, which may be derived from the main memory address for that word or packet. The cache memory also comprises a reference location or register 2 and a comparator 3, shown as an Exclusive-OR gate.

In normal use of the cache memory the associated processor (not shown), when requiring any particular data packet or word from memory, would first check the tags or identifiers of the data packets held in the cache memory, since the cache memory permits faster access than from the main memory (not shown). If the required data packet is not found in the cache memory it has to be read out directly from the main memory, at which point it may be written in to the cache memory for the next time it is required.

When a data packet is written in to the cache memory it is written simultaneously into the reference location 2 and to a storage location 1 selected in accordance with a replacement algorithm, which may for example select either a vacant location or the least recently used usable location. Once a storage location 1 has been selected as usable, as illustrated in Figure 2, the data packet is written in to that location and to the reference location 2, the two data packets are read out from the selected location 1 and the reference location 2, and are compared by means of the Exclusive-OR gate 3. If they are not identical the subsequent read-out of a data packet from that selected location in the cache memory is inhibited, and the subsequent writing of a data packet to that location is prevented, for example by setting the state of a predetermined bit of the tag or identifier to mark that data packet in cache as unusable and to "lock out" that location. Of course if the storage location chosen as the reference location 2 is itself defective it will mark good locations 1 as unusable, rendering the whole of the chip unusable unless an alternative location 2 is available.

It will be appreciated that in a cache memory, unlike in a conventional RAM, adjacent locations do not always have sequential address data in them, the sequency being scrambled by the use of the replacement algorithm, and the number of words of cache memory do not have to be a binary sequence. Poor data retention in the cache memory is to a degree not important, since the data is replicated in main memory, and the effect of one cache "miss" on the overall performance of a program is very small. Indeed even with one hundred locations unusable in a 32kB cache the degradation can be estimated as less than one percent, since the defective locations can be identified and inhibited or locked out, so that the processor goes to main memory to get replacement data. The new data will then be written in a working part of the cache memory and will be found there next time it is required.

In addition to a "write" check a check can be made of parity, one or more bits being included in each data packet to enable a sum check or parity check to be made on read-out. If a location 1 fails such a check it would be locked out.

Additional bit positions may be provided at each location 1 to hold bit values for marking faulty locations, and the cache memory may be arranged to be tested completely following start-up, a test which would be especially worth carrying out if the process of comparison for each location 1 takes an additional processor cycle to accomplish. The checking and marking of defective locations 1 could be done under control of a software routine as part of the processor operating system, running as part of the "supervisor" at initialisation to lock out those locations 1 which are unusable at the time. Locations this marked would then remain unusable for the duration of the current session, between power-ups, or until re-checked by the supervisor routine.

Alternatively on system start-up or re-start every location maybe assumed to be working, every data packet or word written into the cache memory being checked as written. In this way the operation of the system may be protected against subsequent failures due to ageing or poor reliability.

Instead of or in addition to self-marking of defective locations 1 during use, lock-out or inhibition of defective locations may be achieved on first testing by non-volatile means, such as EEPROM, EPROM, fuses or laser cutting, either at wafer test or after packaging, as appropriate.

Main memory may be considered as another stage of cache, for main storage on magnetic tape or disk or on optical disk. Most programs are segmented, and again the data in main memory is duplicated in the main storage. The technique of storing an address in addition to the data may at first seem to be a significant overhead, but if the data is split into 1kB blocks it is necessary to store only an additional twenty two bits (for a 32kB system) with each block to identify the location or sequence of that block in relation to the others. A simple read-back check as described above will tell whether a storage block is usable, if not it can be locked-out. The only difference, however, is that the program would normally require contiguous address space, to that the address sequence itself must be "repaired". However, this can be overcome with a smart memory manager which serves to re-map program perceived memory (virtual) to hardware memory (physical) and can be designed to exclude defective blocks from its perceived memory space.

## Claims

1. A data storage arrangement in which a data packet or word held in a first data store is arranged to be written in to a storage location in a second data store in association with an identifier by means of which said data packet may be located when read-out of said data packet is required, wherein there are provided means to read the data packet from said storage location once it has been written and to compare said data packet as read out with the said data packet as held in said first data store and to inhibit subsequent read-out from said storage location if any discrepancy is detected by said comparison.

2. A data storage arrangement comprising main memory and fast-access cache memory, in which a data packet or word held in said main memory is arranged to be written in to a storage location in said cache memory in association with an address identifier by means of which said data packet may be located when read-out is required, wherein there are provided means to read the data packet from said storage location once it has been written and to compare said data packet as read out with the same data packet as held in main memory, and to inhibit subsequent writing of a data packet to or read-out of said data packet from said storage location in the cache memory if any discrepancy is detected by the comparison.

3. In a data processing arrangement a method of writing data from main memory to cache memory comprising the steps of writing a given data word from said main memory to a storage location in said cache memory in association with a tag or identifier by means of which said data word may be retrieved when said data word is to be read out, reading the data word from said storage location and comparing it with the given data word from said main memory, and inhibiting subsequent retrieval and read-out of said data word from said location if any discrepancy is detected by the comparison.

4. A method in accordance with Claim 3 wherein the given data word is written in to a reference register or a reference location in said cache memory for the purpose of making said comparison.

5. A method in accordance with Claim 3 or Claim 4 wherein one or more additional data bits are included in said data word, and said subsequent retrieval and read-out from said location are inhibited if the data word on read-out from said location fails a sum check or parity check.

6. In a data processing arrangement a method of writing data from a first storage medium to a second storage medium, comprising the steps of writing a given block of data from said first storage medium to a storage location in said second storage medium in association with an identifier by means of which said block of data may be retrieved when said block of data is to be read out, reading the block of data from said storage location once it has been written and comparing it with the same block of data as held in said first storage medium, and inhibiting subsequent read-out of said block of data if any discrepancy is detected by the comparison.

7. A method in accordance with Claim 6 wherein the identifiers of blocks of data stored out of sequence are mapped so as to exclude defective storage locations from the memory space to be used.
